**Europäisches Patentamt**

**European Patent Office**

**Office européen des brevets**

(19)

(11) Veröffentlichungsnummer : **0 418 705 B1**

(12) **EUROPÄISCHE PATENTSCHRIFT**

(45) Veröffentlichungstag der Patentschrift :
**15.12.93 Patentblatt 93/50**

(51) Int. Cl.$^5$ : **H01S 3/103,** H01S 3/085

(21) Anmeldenummer : **90117468.0**

(22) Anmeldetag : **11.09.90**

(54) **Interferometrischer Halbleiterlaser.**

(30) Priorität : **22.09.89 DE 3931588**

(43) Veröffentlichungstag der Anmeldung :
**27.03.91 Patentblatt 91/13**

(45) Bekanntmachung des Hinweises auf die
Patenterteilung :
**15.12.93 Patentblatt 93/50**

(84) Benannte Vertragsstaaten :
**DE FR GB IT NL SE**

(56) Entgegenhaltungen :
APPL. PHYS. LETT., Band 52, Heft 10, 7. März
1988, Seiten 767-769; J. SALZMAN et al.:
"Cross coupled cavity semiconductor laser"
IEEE JOURNAL OF QUANTUM ELECTRONICS,
Band QE-22, Heft 9, September 1986, Seiten
1557-1567; J. MARCOU et al.: "Analysis of
Bragg grating coupling between two channel
waveguides intersecting at a right angle"
JOURNAL OF APPLIED PHYSICS, Band 63,
Heft 2, 15. Januar 1988, Seiten 291-294; M.C.
WU et al.: "Wavelength tuning and switching
of a coupled distributed feedback and Fa-
bry-Perot cavity laser"
ELECTRONICS LETTERS, Band 21, Heft 24,
November 1985, Seiten 1138-1140; Y.-H. WU et
al.: "Molecular-beam-epitaxy-grown single-
longitudinal-mode GaAs-AlGaAS interferometric lasers on stepped-channelled substrates"
ELECTRONICS LETTERS, Band 19, Heft 22,
Oktober 1983, Seiten 926-927; I.H.A. FATTAH
et al.: "Electrical tuning of semiconductor interferometric laser"
ELECTRONICS LETTERS, Band 26, Heft 4, 15.
Februar 1990, Seiten 243-244; M. SCHILLING
et al.: "Widely tunable y-coupled cavity integrated interferometric injection laser"

(73) Patentinhaber : **Alcatel SEL
Aktiengesellschaft
Lorenzstrasse 10
D-70435 Stuttgart (DE)**
(84) **DE**
Patentinhaber : **ALCATEL N.V.
Strawinskylaan 341, (World Trade Center)
NL-1077 XX Amsterdam (NL)**
(84) **FR GB IT NL SE**

(72) Erfinder : **Eisele, Hartmut, Dr.
Nelkenweg 6
D-7302 Ostfildern/Ruit (DE)**
Erfinder : **Hildebrand, Olaf, Dr.
Luise-Berger-Strasse 21
D-7000 Stuttgart 61 (DE)**
Erfinder : **Mozer, Albrecht, Dr.
Freiberger Strasse
D-7120 Bietigheim (DE)**
Erfinder : **Schilling, Michael
Rastatter Strasse 38
D-7000 Stuttgart 31 (DE)**
Erfinder : **Schweizer, Heinz, Dr.
Niersteiner Strasse 18
D-7000 Stuttgart 31 (DE)**
Erfinder : **Spalthoff, Ulrich, Dr.
Niersteiner Strasse 8
D-7000 Stuttgart 31 (DE)**
Erfinder : **Wünstel, Klaus, Dr.
Stiegelstrasse 18
D-7141 Schwieberdingen (DE)**

(74) Vertreter : **Pohl, Herbert, Dipl.-Ing et al
Alcatel SEL AG Patent- und Lizenzwesen
Postfach 30 09 29
D-70449 Stuttgart (DE)**

## Beschreibung

Die Erfindung betrifft einen elektrisch durchstimmbaren, interferometrischen Halbleiterlaser mit wenigstens drei in einer Ebene aufeinanderstoßenden Segmenten, die auf einem Halbleiterwafer monolithisch integriert sind und die jeweils mindestens eine laseraktive Zone und an ihrem freien Ende einen Spiegel aufweisen, und mit einem Strahlteiler, über den die Segmente miteinander verbunden sind.

Ein interferometrischer Halbleiterlaser ist ein Halbleiterlaser, der nach dem Prinzip des Michelson- oder des Mach-Zehnder-Interferometers aufgebaut ist. Gegenüber einem Laser mit einem Fabry-Pérot-Resonator bietet er den Vorteil, daß er bei guter Unterdrückung von Seitenmoden des Laserlichtes im Einmodenbetrieb emittiert. Darüber hinaus ist er bei Strominjektion zur Änderung seiner optischen Länge viel stärker durchstimmbar als ein Laser mit einem DFB-Resonator. Dies macht ihn für zahlreiche Anwendungen geeignet: als Sendelaser in Mehrkanal-Kommunikationssystemen mit Wellenlängenmultiplexierung, als Lokaloszillator in kohärenten Systemen zur präzisen Definition von Kanalwellenlängen, und als Logikelement: bei diesem werden die logischen Zustände "0", "1" durch zwei Wellenlängen $\lambda_1$, $\lambda_2$ repräsentiert.

Aus Appl. Phys. Lett. <u>52</u> (1988), S. 767-769, ist es bekannt, einen derartigen, monolithisch integrierten, kontinuierlich durchstimmbaren Laser zu konstruieren, der aus wenigstens drei einzelnen Laser-Kavitäten besteht, die unabhängig voneinander über elektrische Kontakte gesteuert werden. Vier Segmente, die als optische Resonatoren wirken, bilden einen kreuzförmigen Laser, an dessen Kreuzungspunkt sich unter einem Winkel von 45° bezogen auf eines der Segmente ein Strahlteiler befindet.

Nach dem gleichen Prinzip ist ein Halbleiterlaser aufgebaut, der nur drei Segmente enthält, die unterschiedliche Längen $L_1$, $L_2$, $L_3$ aufweisen.

Ein solcher Halbleiterlaser entsteht auf einer (100) GaAs/GaAlAs-Doppelheterostruktur durch metallorganische Gasphasenepitaxie, in der die Segmente in den [011]- und [011]-Richtungen photolithographisch aufgewachsen werden. Danach werden die Segmente mit einem Dielektrikum beschichtet und Elektroden angebracht, auf der Rückseite des Halbleiter-Substrats metallisiert und an den Enden gespalten.

An dem Verbindungspunkt der drei Segmente entstehen durch Beschießen mit einem Galliumionenstrahl schmale Gräben, um den Strahlteiler zu bilden. Die Gräben ragen bis auf einen Abstand von 0,1 μm zur laseraktiven Zone herab, so daß eine nicht vernachlässigbare Kopplung zwischen den Segmenten entsteht.

Gegenüber dem Modenspektrum eines einzelnen Lasers ergibt sich für den interferometrischen Halbleiterlaser aufgrund der unterschiedlichen Längen $L_1$, $L_2$, $L_3$ der drei Segmente eine größere Verstärkung jeder n-ten Mode, wobei gilt:

$$\frac{(L_2 + L_3) - (L_1 + L_2)}{(L_2 + L_3) + (L_1 + L_2)} = \frac{1}{n}$$

Trotz verhältnismäßig großer Längen $L_1$, $L_2$, $L_3$ der einzelnen Segmente spielt nur die Differenz der Längen der Laserkavitäten $(L_2 + L_3) - (L_1 + L_2)$ eine Rolle für die Trennung der Moden, während bei einem Laser mit einem Fabry-Pérot-Resonator Moden mit der Frequenzdifferenz c/2L auftreten; dabei bedeuten c die Lichtgeschwindigkeit und L die Länge der Laserkavität. Nur dann, wenn der Laser hinreichend kurz ist, schwingt er auf einer einzigen Frequenz. Dieser interferometrische Halbleiterlaser hat jedoch den Nachteil, daß sich die Frequenz des von ihm emittierten Lichtes nicht ändern läßt.

Es ist die Aufgabe der Erfindung, einen Halbleiterlaser der eingangs genannten Art zu schaffen, dessen Emissionsfrequenz veränderbar ist und der für die optische Nachrichtenübertragung geeignet ist, d.h. im Wellenlängenbereich von 1,3 μm und 1,55 μm emittiert.

Die Aufgabe wird bei einem Halbleiterlaser der eingangs genannten Art dadurch gelöst, daß der Strahlteiler zwei Elektroden aufweist, über die sich durch einen Strom die Transmission und Reflexion des Laserlichtes zwischen den Segmenten steuern lassen.

Vorteilhafte Weiterbildungen ergeben sich aus den Unteransprüchen. Besonders vorteilhaft ist ein Halbleiterlaser mit Quantum-Well-Schichtpaketen als laseraktiven Zonen, da er eine planare Oberfläche hat und die Trennung zwischen dem Strahlteiler und den Wellenleitern sowie der Monitordiode durch Implantieren oder Eindiffundieren von Fremdatomen durchgeführt wird, wodurch sich die Kristallstruktur ändert. Dieses Verfahren wird als "selektives Disordering" bezeichnet.

Eine andere, besonders vorteilhafte Weiterbildung weist einen zweiten Strahlteiler sowie drei Monitordioden auf, die dazu dienen, die Phase, die Leistung und die Filterwellenlänge des ausgestrahlten Laserlichts jeweils einzeln zu steuern.

Nachstehend wird die Erfindung anhand von Ausführungsbeispielen näher erläutert. Es zeigen:

Fig. 1-3      einen interferometrischen Halbleiterlaser mit einem holographischen Gitter als Strahlteiler,

Fig. 4-6      einen interferometrischen Halbleiterlaser mit einem geätzten Strahlteiler,

Fig. 7-9        einen interferometrischen Halbleiterlaser mit Quantum-Well-Lasern,

Fig. 10-11      einen interferometrischen Halbleiterlaser mit zwei Strahlteilern und

Fig. 12        einen interferometrischen Halbleiterlaser mit einem Y-Koppler.

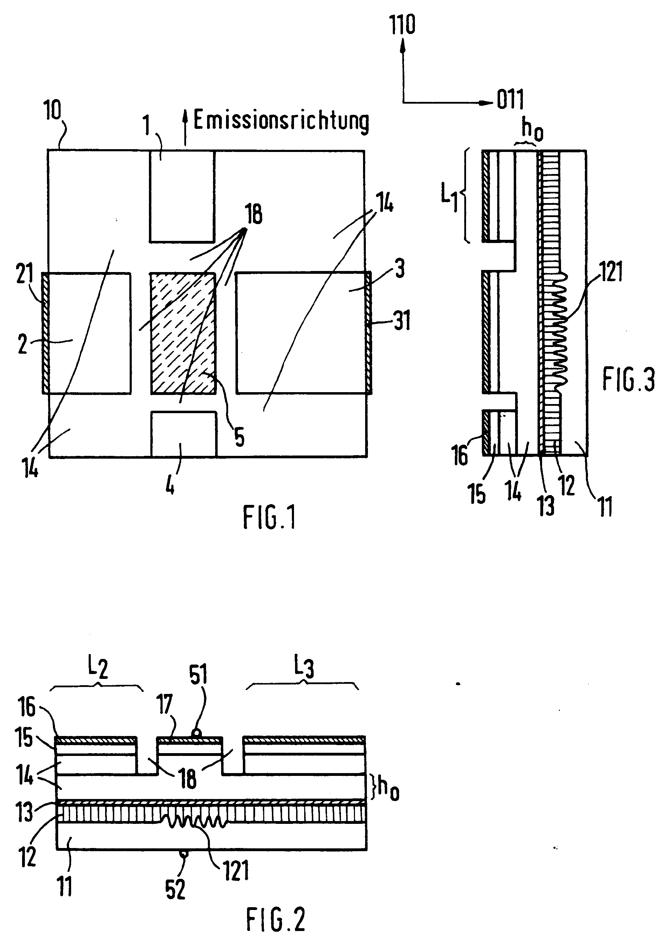

Ein interferometrischer Halbleiterlaser (Fig. 1) besteht aus drei Segmenten 1, 2, 3 und einer Monitordiode 4, die im rechten Winkel zueinander auf einem rechteckigen Halbleiterchip 10 angeordnet sind. Dieses ist auf der Basis eines Halbleitersubstrats 11 (Fig. 2) aufgebaut.

Die Segmente 1, 2, 3 und die Monitordiode 4, die aus mehreren übereinander liegenden Schichten 12, ..., 16 bestehen (vgl. Fig. 2) sind über einen Strahlteiler 5 miteinander verbunden. Jedoch ragen Gräben 18 bis zur Tiefe der Schicht 14 (vgl. Fig. 2) in die Folge der Schichten 11, ..., 16 zwischen den Segmenten 1 bis 3 sowie der Monitordiode 4 einerseits und dem Strahlteiler 5 andererseits hinein.

Die Segmente 2 und 3 erstrecken sich in [011]-Richtung auf dem Halbleitersubstrat 11 und weisen an ihren freien Enden Spiegelflächen 21 bzw. 31 auf, die durch Ätzen oder Spalten der Kristallflächen entstanden sind. Das nutzbare Laserlicht wird aus dem Segment 1 in [110]-Richtung emittiert.

Das Halbleitersubstrat 11 des im Querschnitt dargestellten Halbleiterlasers (Fig. 2) besteht aus n-Indiumphosphid. Entweder das Halbleitersubstrat 11 oder eine auf es aufgebrachte Pufferschicht (hier nicht dargestellt) weist im Bereich des Strahlteilers 5 ein holographisches Gitter 121 auf, das eine Periodizität 1. Ordnung oder 2. Ordnung aufweist. Welche der beiden Periodizitäten gewählt wird, hängt davon ab, wie stark die Kopplung der Wellenleiter 1 bis 3 untereinander sein soll. Oberhalb des Halbleitersubstrats 11 oder der Pufferschicht schließt sich eine Schicht 12 aus n-InGaAsP an. Sie bildet eine Wellenleiterzone, die Licht der Wellenlänge 1,30 $\mu$m leitet.

Darüber liegt die Schicht 13 aus nicht-dotiertem InGaAsP; sie bildet die für Licht der Wellenlänge 1,55 $\mu$m durchlässige, laseraktive Zone.

Oberhalb der Schicht 13 folgt eine ebenfalls als Mantelschicht dienende Schicht 14 aus p-InP, die eine Dicke von einem Mikrometer hat. Die Schicht 15 dient als Kontaktschicht; sie besteht aus $p^+$-InGaAs und liegt unter der Metallschicht 16.

Die Schichten 14 bis 16 werden in Längs- und in Querrichtung durch die Gräben 18 durchbrochen, die den Strahlteiler 5 seitlich begrenzen.

Im Bereich der Gräben 18 auf den von den Wellenleitern 1,2,3 und der Monitordiode 4 ausgesparten Eckflächen hat die Schicht 14 eine Höhe $h_o$. Unterhalb und oberhalb des Strahlteilers 5 befinden sich Elektroden 51, 52, über die sich durch Strominjektion Transmission und Reflexion des holographischen Gitters 121, - und damit die Kopplung unter den Wellenleitern 1 bis 3 -, über die Abhängigkeit des Brechungsindex' von der Ladungsträgerkonzentration steuern läßt. Auch die Wellenleiter 1 bis 3 und die Monitordiode 4 weisen auf der Metallschicht 16 und unterhalb des Halbleitersubstrats (hier nicht dargestellte) Elektroden auf, über die sie gesteuert werden. Die Segmente 1 bis 3 werden in Flußrichtung und die Monitordiode in Sperrichtung betrieben; letztere regelt die Injektionsströme für die Wellenleiter 1 bis 3, um deren Lichtemission zu ändern.

Dabei lassen sich die Moden des emittierten Lichts über einen weiten Bereich hin verschieben. Die einmodige Emission kann bis zu 0,4 % von der Wellenlänge 1,55 $\mu$m abweichen. Und diese Abweichung läßt sich durch kontinuierliches Durchstimmen der Injektionsströme bewirken.

Um genügend Licht in den Strahlteiler 5 einzukoppeln, sind die Segmente 2 und 3 150 bis 200 $\mu$m breit. In ihnen bildet die Schicht 13 sogenannte "Broad-Area-Laser". Die laseraktive Zone des Segments 1 (Fig. 2) hat hingegen nur eine Breite von 2 $\mu$m. Sie stellt einen Gratwellenleiterlaser dar. Die Segmente 1,2,3 haben die Längen $L_1$, $L_2$, $L_3$ (Fig. 2, 3).

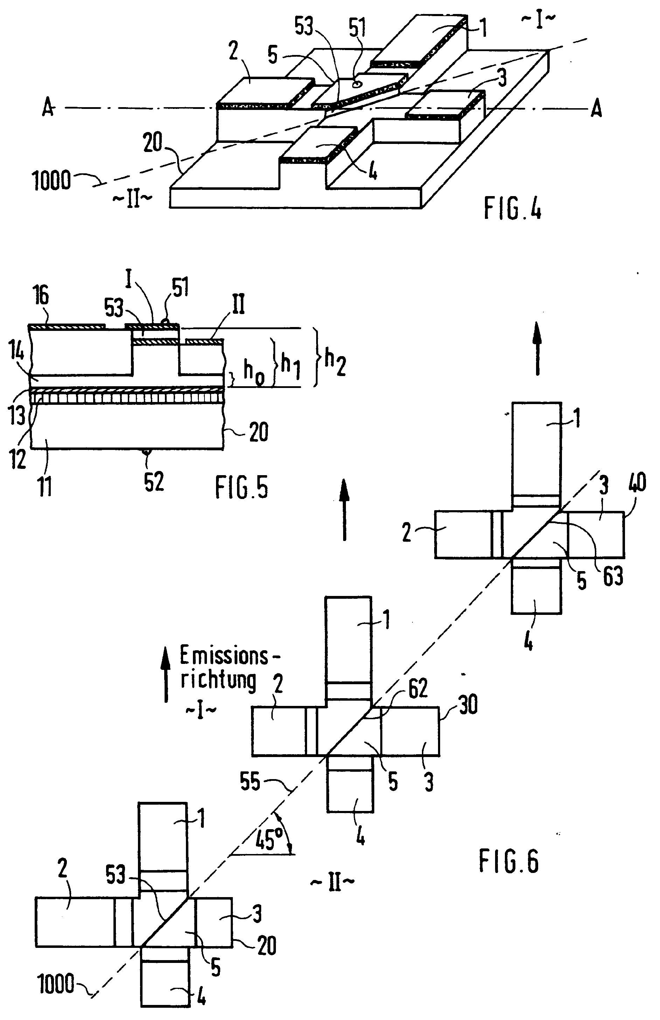

In einem anderen Ausführungsbeispiel weist der Strahlteiler 5 eines interferometrischen Halbleiterlasers 20 anstelle des holographischen Gitters einen teildurchlässigen Spiegel 53 auf (Fig. 4). Ein solcher Halbleiterlaser 20 entsteht, indem diesseits einer Winkelhalbierenden 1000, die durch die dem Strahlteiler 5 entsprechende Fläche verläuft, ein Gebiet II eine niedriger gelegene Oberfläche hat als ein Gebiet I jenseits der Winkelhalbierenden 1000.

Aus einer Schnittansicht (Fig. 5) entsprechend der Linie A-A von Fig. 4 ist ersichtlich, daß die Schicht 14 im Gebiet I im Bereich der Segmente 1 und 2 sowie auf der einen Hälfte des Strahlteilers 5 entsprechenden Fläche eine Höhe $h_2$, im Gebiet II im Bereich des Wellenleiters 3, der Monitordiode 4 und auf der anderen Hälfte des Strahlteilers 5 eine Höhe $h_1$ und außerhalb der Segmente 1-3, der Monitordiode 4 und des Strahlteilers 5 die Höhe $h_o$ aufweist. Eine Kontaktschicht ist nicht vorhanden. Die Segmente 1 bis 3, die Monitordiode 4 und der Strahlteiler 5 im Gebiet I weisen die Metallschicht 16 auf.

Mehrere solcher, gleich aufgebauter Halbleiterlaser 20, 30, 40 (Fig. 6) sind auf dem Halbleitersubstrat 11 integriert. Sie sind in Längs- und in Querrichtung so gegeneinander versetzt, daß die Winkelhalbierende 1000 des Strahlteilers 5 des Halbleiterlasers 20 ebenfalls die Winkelhalbierende der Strahlteiler 5 der beiden anderen Halbleiterlaser 10, 20, 30, 40 bildet. Da alle Strahlteiler 5 einen quadratischen Grundriß haben, werden sie unter einem 45°-Winkel geschnitten.

Alle Segmente 1, 2, 3 enthalten in diesem Fall einen Gratwellenleiterlaser, der jeweils 2 bis 3 $\mu$m breite laseraktive Zonen aufweist. Durch die unterschiedliche Dicke der Gebiete I und II haben sie unterschiedliche, über das Halbleitersubstrat 11 und die Schichten 12 bis 14 gemittelte Brechungsindices $n_I$ bzw. $n_{II}$. Der Unterschied der Brechungsindices ist ein Maß für die Kopplung des Laserlichtes zwischen den Segmenten 1 bis 3. Je nach gewünschter Kopplung durch den Strahlteiler 5 wird die Schicht 14 auf eine entsprechende Höhe $h_1$ geätzt.

Aufgrund der besseren Kopplung des Laserlichtes zwischen den Segmenten 1 bis 3, die der geätzte Strahlteiler 5 gegenüber dem holographischen Gitter bietet, brauchen die Segmente 2 und 3 keine "Broad-Area-Laser" aufzuweisen. Sie weisen daher wie das Segment 1 Gratwellenleiterlaser und haben dieselbe Breite wie das Segment 1.

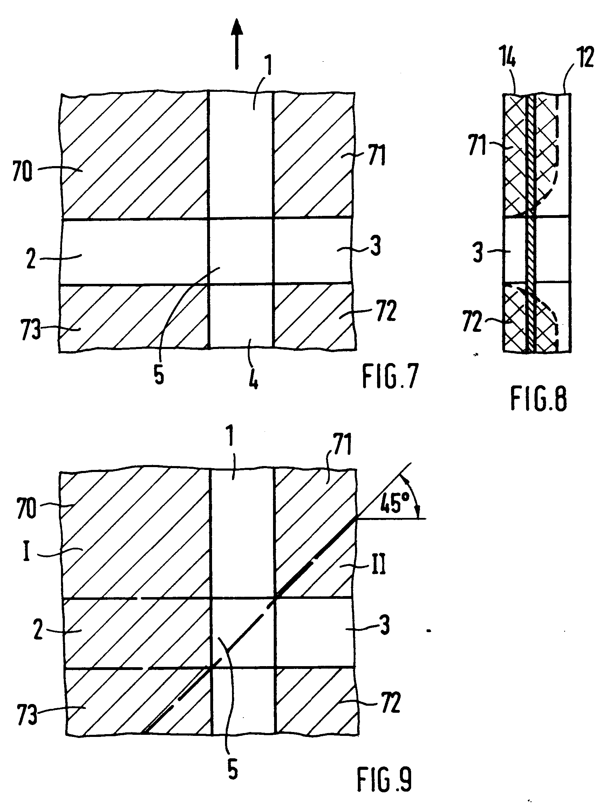

An die Stelle der in den Gratwellenleiterlasern der Segmente 1 bis 3 verwendeten Doppelhetrostruktur treten in einem dritten Ausführungsbeispiel Multi-Quantum-Well-Schichten, von denen in jedem Segmente 1, 2, 3 (Fig. 7) 10 bis 20 übereinanderliegend angeordnet sind. Anstelle einer einzigen laseraktiven Zone in der Schicht 13 (vgl. Fig. 5) sind 10 bis 20 Schichten vorhanden, die z.B. abwechselnd aus InGaAsP und InP bestehen.

Die Herstellung eines derartigen Halbleiterlasers mit Multi-Quantum-Well-Schichten erfolgt dadurch, daß auf dem Halbleitersubstrat 11 oder einer (hier nicht dargestellten) Pufferschicht nacheinander die Schicht 12, die 10 bis 20 Multi-Quantum-Well-Schichten und die Schicht 14 (Fig. 8) epitaktisch aufgetragen werden. Anschließend wird die kreuzförmige Oberfläche des Halbleiterlasers durch eine Maske lithographisch bedeckt, so daß in einem darauffolgenden Implantations- oder Diffusionsschritt die Kristallstruktur ausschließlich von Bereichen 70 bis 73 (Fig. 7) durch Fremdatome, z.B. Zinkatome oder Atome des Materials, aus dem die Bereiche 70 bis 73 bestehen, umstrukturiert wird. Das durch die Atome umstruktuierte Gebiet II (Fig. 8) reicht bis zur Tiefe der Schicht 12 hinab.

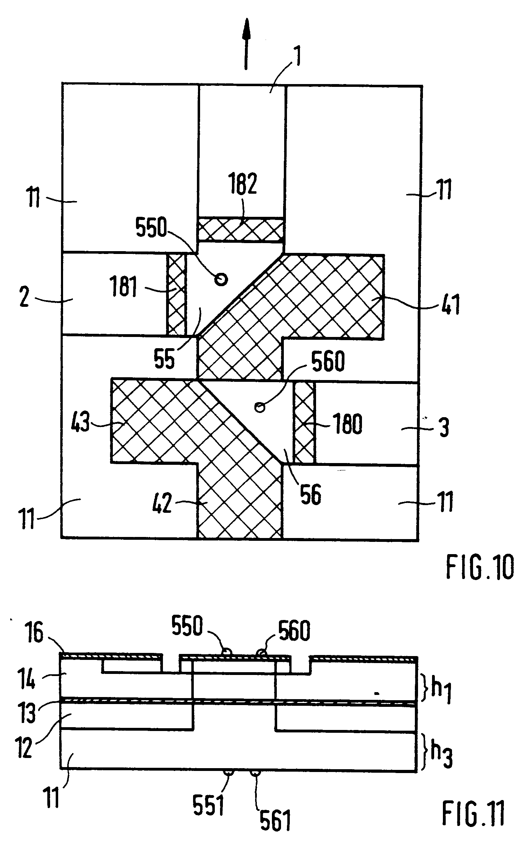

In einem zweiten Implantations- oder Diffusionsschritt wird ausschließlich das Gebiet I (Fig. 9) ein zweites Mal mit Atomen in seiner Kristallstruktur umgeordnet. Auf diese Weise haben das Segment 3 und die Monitordiode 4 einen anderen Brechungsindex als die Segmente 1 und 2. In diesem Fall legt die Stärke Umstrukturierung die Kopplung zwischen den Segmenten 1 und 2 einerseits und dem Segment 3 andererseits fest.

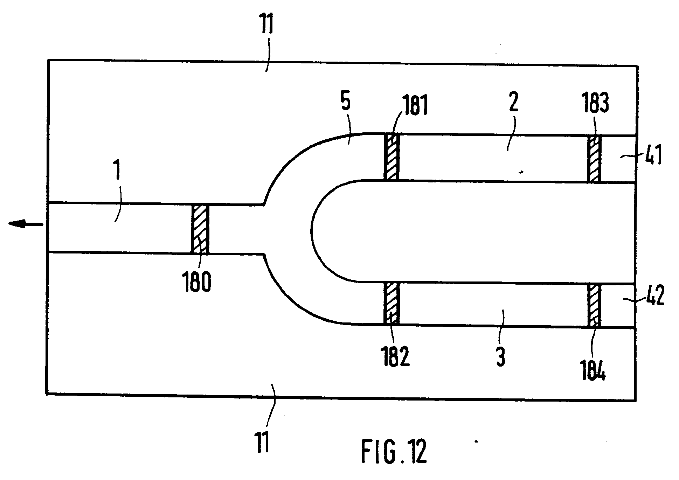

Ein anderer Halbleiterlaser weist zwei Strahlteiler 55, 56 (Fig. 10) auf. Diese koppeln Licht aus den Segmenten 1 bis 3 in drei Monitordioden 41, 42, 43 aus. Die Monitordiode 41 steuert die Phase des Laserlichtes. Sie regelt den Strom, der in die Wellenleiter 2 und 3 injiziert wird. Die Monitordiode 42 steuert die Leistung des Laserlichtes, indem sie die Stärke des Stromes regelt, der in das Segment 1 injiziert wird. Ebenfalls in das Segment 1 wird der Strom injiziert, den die Monitordiode 43 zur Regelung der Filterwellenlänge erzeugt. Die Strahlteiler 55, 56 und die Segmente 1 bis 3 sind untereinander und von den Monitordioden 41 bis 43 durch Gräben 180 bis 182 getrennt, die von der Oberfläche aus bis zur Schicht 14 hinabreichen, die dort eine Höhe $h_1$ (Fig. 11) aufweist. Beide Strahlteiler weisen Elektroden 550, 551 bzw. 560, 561 auf, über die sich die Kopplung steuern läßt. Die Segmente 1 bis 3 und die Strahlteiler 55, 56 weisen die Metallschicht 16 (vgl. auch Fig. 2) auf. Außerhalb der Segmente 1 bis 3, der Strahlteiler 55, 56, der Monitordioden 41 bis 43 und der zwischen ihnen liegenden Gräben 180 bis 182 ist nur das von der Oberfläche her teilweise weggeätzte Halbleitersubstrat 11 vorhanden, das dort eine Höhe $h_3$ hat.

Anstelle des Schichtenaufbaus gemäß Fig. 2 läßt sich ein Halbleiterlaser mit zwei Strahlteilern 55, 56 ebenfalls mit Quantum-Well-Lasern realisieren (vgl. Fig. 9).

Ein derartiger Halbleiterlaser mit Quantum-Well-Lasern ist besonders kostengünstig herzustellen. Alle für das Laserlicht benötigten Steuersignale werden von den integrierten Monitordioden 41 bis 43 geliefert; eine externe Regelung entfällt.

Ein weiterer, auf dem Halbleitersubstrat 11 integrierter Halbleiterlaser (Fig. 12) weist einen Strahlteiler 5 in Form eines "Y" auf, der die Segmente 1 bis 3 miteinander verbindet und von diesen durch die Gräben 180 bis 182 getrennt sind. Die Segmente 2 und 3 sind ihrerseits durch Gräben 183, 184 von den Monitordioden 41, 42 getrennt.

## Patentansprüche

1. Elektrisch durchstimmbarer, interferometrischer Halbleiterlaser mit wenigstens drei in einer Ebene aufeinanderstoßenden Segmenten, die auf einem Halbleiterwafer monolithisch integriert sind und die jeweils mindestens eine laseraktive Zone und an ihrem freien Ende einen Spiegel aufweisen, und mit einem Strahlteiler, über den die Segmente miteinander verbunden sind,
   **dadurch gekennzeichnet,**
   daß der Strahlteiler (5) zwei Elektroden (51, 52) aufweist, über die sich durch einen Strom die Transmission und Reflexion des Laserlichtes zwischen den Segmenten (1, 2, 3) steuern lassen.

2. Halbleiterlaser nach Anspruch 1,
dadurch gekennzeichnet,
daß der Strahlteiler (5) ein holographisches Gitter (121) aufweist.

3. Halbleiterlaser nach Anspruch 1,
dadurch gekennzeichnet,
daß der Strahlteiler (5) als Y-Koppler ausgebildet ist.

4. Halbleiterlaser nach Anspruch 2,
dadurch gekennzeichnet,
   - daß eines der Segmente (1) einen Gratwellenleiterlaser aufweist und
   - daß die beiden anderen Segmente (2, 3) einen Broad-Area-Laser aufweisen.

5. Halbleiterlaser nach Anspruch 1,
dadurch gekennzeichnet,
daß jedes der drei Segmente (1, 2, 3) einen Gratwellenleiterlaser aufweist.

6. Halbleiterlaser nach Anspruch 1,
dadurch gekennzeichnet,
daß eine Monitordiode (4) vorhanden ist, die mit zweien der Segmente (2, 3) einen rechten Winkel bildet und die die Ausgangsleistung des Laserlichtes steuert.

7. Halbleiterlaser nach Anspruch 1,
dadurch gekennzeichnet,
daß der Strahlteiler (5) einen teildurchlässigen Spiegel (53) aufweist, der durch einen Höhenunterschied zwischen zwei Segmenten (1, 2) und der einen Hälfte des Strahlteilers (5) einerseits sowie dem dritten Segment (3), der Monitordiode (4) und der anderen Hälfte des Strahlteilers (5) andererseits gebildet ist.

8. Halbleiterlaser nach Anspruch 7,
dadurch gekennzeichnet,
daß weitere Halbleiterlaser (30, 40) vorhanden sind, die denselben Höhenunterschied wie dieser (20) aufweisen, und deren Spiegel (62, 63) auf der Linie liegen, die durch den Höhenunterschied gebildet wird.

9. Halbleiterlaser nach Anspruch 1,
dadurch gekennzeichnet,
daß die Segmente (1, 2, 3) Quantum-Well-Laser aufweisen.

10. Halbleiterlaser nach Anspruch 1,
dadurch gekennzeichnet,
   - daß zwei Strahlteiler (55,56) vorhanden sind und
   - daß drei Monitordioden (41,42,43) vorhanden sind, durch die die Phase, die Leistung und die Filterwellenlänge des Laserlichtes steuerbar sind.

## Claims

1. An electrically tunable, interferometric semiconductor laser including at least three segments which abut on one another in one plane, are monolithically integrated on a semiconductor wafer and are each provided with at least one laser-active zone and with a mirror at their free ends, the semiconductor laser further including a beam splitter by means of which the segments are connected with one another, characterised in that the beam splitter (5) includes two electrodes (51, 52) by way of which the transmission and reflection of the laser light between the segments (1, 2, 3) can be controlled by means of a current.

2. A semiconductor laser according to claim 1, characterised in that the beam splitter (5) includes a holographic grating (121).

3. A semiconductor laser according to claim 1, characterised in that the beam splitter (5) is configured as a Y coupler.

4. A semiconductor laser according to claim 2, characterised in that
   - one of the segments (1) is provided with a ridge waveguide laser; and
   - the other two segments (2, 3) are provided with broad-area lasers.

5. A semiconductor laser according to claim 1, characterised in that each one of the three segments (1, 2, 3) includes a ridge waveguide laser.

6. A semiconductor laser according to claim 1, characterised in that a monitor diode (4) is provided which forms a right angle with two of the segments (2, 3) and controls the output power of the laser light.

7. A semiconductor laser according to claim 1, characterised in that the beam splitter (5) includes a partially transparent mirror (53) which is formed by the difference in height between two segments (1, 2) and the one half of the beam splitter (5), on the one hand, as well as the third segment (3), the monitor diode (4) and the other half of the beam splitter (5), on the other hand.

8. A semiconductor laser according to claim 7, characterised in that further semiconductor lasers (30, 40) are provided which have the same height differences as the former (20) and whose mirrors (62, 63) lie on the line formed by the difference in height.

9. A semiconductor laser according to claim 1, characterised in that the segments (1, 2, 3) are provided with quantum-well lasers.

10. A semiconductor laser according to claim 1,
    characterised in that
    - two beam splitters (55, 56) are provided; and
    - three monitor diodes (41, 42, 43) are provided with which the phase, the power and the filter wavelength of the laser light can be controlled.


**Revendications**

1. Laser interférométrique à semi-conducteur, accordable électriquement, présentant au moins trois segments qui viennent au contact l'un de l'autre dans un plan, qui sont intégrés de façon monolithique sur une microplaquette de semi-conducteur et qui présentent chacun au moins une zone à activité laser et, à son extrémité libre, une surface réfléchissante, et présentant aussi un séparateur de faisceaux par l'intermédiaire duquel les segments sont reliés les uns aux autres,
   laser caractérisé,
   par le fait que le séparateur de faisceaux (5) présente deux électrodes (51, 52) par l'intermédiaire desquelles on peut piloter, au moyen d'un courant, la transmission et la réflexion du faisceau laser entre les segments (1, 2, 3).

2. Laser à semi-conducteurs selon la revendication 1,
   caractérisé,
   par le fait que le séparateur de faisceaux (5) présente une grille holographique (121).

3. Laser à semi-conducteur selon la revendication 1,
   caractérisé,
   par le fait que le séparateur de faisceaux (5) a la forme d'un coupleur en Y.

4. Laser à semi-conducteur selon la revendication 2,
   caractérisé,
   - par le fait que l'un des segments (1) présente un laser à guide d'ondes en arête et
   - par le fait que les deux autres segments (2, 3) présentent un laser à grande surface.

5. Laser à semi-conducteur selon la revendication 1,
   caractérisé,

par le fait que chacun des trois segments (1, 2, 3) présente un laser à guide d'ondes en arête.

6. Laser à semi-conducteur selon la revendication 1,
   caractérisé,
   par le fait qu'il y a une diode de surveillance (4) qui forme un angle droit avec deux des segments (2, 3) et pilote la puissance de sortie du faisceau laser.

7. Laser à semi-conducteur selon la revendication 1,
   caractérisé,
   par le fait que le séparateur de faisceaux (5) présente un miroir partiellement transparent (53) qui est formé par une différence de hauteur entre deux segments (1, 2) et la première moitié du séparateur de faisceaux (5) d'une part et le troisième segment (3), la diode de surveillance (4) et l'autre moitié du séparateur de faisceaux (5) d'autre part.

8. Laser à semi-conducteur selon la revendication 7,
   caractérisé,
   par le fait qu'il y a d'autres lasers à semi-conducteurs (30, 40) qui présentent la même différence de hauteur que ce dernier (20) et dont les miroirs (62, 63) sont situés sur la ligne formée par la différence de hauteur.

9. Laser à semi-conducteur selon la revendication 1,
   caractérisé,
   par le fait que les segments (1, 2, 3) présentent un laser de Quantum-Well.

10. Laser à semi-conducteur selon la revendication 1,
    caractérisé,
    - par le fait qu'il y a deux séparateurs de faisceaux (55, 56) et
    - par le fait qu'il y a trois diodes de surveillance (41, 42, 43) grâce auxquelles on peut piloter la phase, la puissance et la longueur d'onde de filtrage du faisceau laser.

**FIG.1**

**FIG.2**

**FIG.3**

FIG.4

FIG.5

FIG.6

FIG.7

FIG.8

FIG.9

FIG.10

FIG.11

FIG.12